# EUROPEAN PATENT SPECIFICATION

(11) **EP 0 749 045 B1**
(45) Date of publication and mention of the grant of the patent: **14.03.2001**
(21) Application number: 96107762.5
(22) Date of filing: 15.05.1996
(51) Int. Cl.: G03F 7/021, G03F 7/032

(54) **Photosensitive compositions and their use in lithographic plates**
Lichtempfindliche Zusammensetzungen und ihre Verwendung für lithographischen Platten
Compositions photosensibles et leur utilisation pour des plaques lithographiques

(30) Priority: 17.05.1995 DE 19518118
(43) Date of publication of application: 18.12.1996
(73) Proprietor: Kodak Polychrome Graphics LLC, Norwalk, Connecticut 06851 (US)
(72) Inventor: Savariar-Hauck, C., 37520 Osterrode/Harz (DE); Baumann, H., 37520 Osterrode/Harz (DE); Timpe, H.-J., 37520 Osterrode/Harz (DE); Dwars, U., 37520 Osterrode/Harz (DE)
(74) Representative: VOSSIUS & PARTNER

(56) References cited:
- EP-B- 0 363 757
- GB-A- 2 048 898
- US-A- 3 996 237
- PATENT ABSTRACTS OF JAPAN vol. 16, no. 148 (C-928), 13 April 1992 & JP 04 005281 A (NIPPON KAYAKU CO LTD), 9 January 1992,
- PATENT ABSTRACTS OF JAPAN vol. 14, no. 438 (P-1108), 19 September 1990 & JP 02 171752 A (NIPPON KAYAKU CO LTD)

## Description

The present invention relates to photosensitive compositions which, *inter alia*, are extraordinarily suitable for preparing lithographic plates.

Nowadays, photosensitive compositions usable particularly for high-performance lithographic plates must fulfill high requirements.

The discussion of improving the properties of photosensitive compositions and thus also of the corresponding lithographic plates essentially deals with two different ways. One of them deals with the improvement of the properties of the photosensitive components in the compositions (frequently diazo compounds, photo polymers etc.), the other one with the search for novel polymeric compounds ("binders") which are to control the physical properties of the photosensitive layers. In particular the latter way is decisive for lithographic plates because the behavior in the developing and printing processes (such as developability, ink receptivity, scratch resistance, consistency in the number of prints produced) is decisively influenced by the polymer binders. Also shelf life and photosensitivity of the materials are strongly influenced by the polymeric compounds.

The polymeric binders therefore exhibit various structural elements for satisfying the extensive requirements, which may have different effects on individual properties. For instance, hydrophilic structural elements such as carboxyl groups, hydroxyl groups and the like generally promote the developability of the photosensitive compositions in aqueous alkaline developers and partly ensure sufficient adhesion to polar substrates. Hydrophobic structural elements, on the other hand, reduce the capability of being developed in the above-mentioned developers, but ensure the good ink receptivity used in the printing process, which is indispensable in lithographic plates.

Due to the broad range of requirements regarding the polymeric binders, for many years there have been extensive studies on the synthesis and optimization of these substances for photosensitive compositions, cf. e.g. H. Baumann and H.J. Timpe: "Chemical Aspects of Offset Printing" in *J*. *prakt*. *Chem*. *Chemiker-Zeitung* [Journal for chemists] **336** (1994) pages 377 - 389.

EP-A-135 026, EP-A-186 156 and US-A-4 731 316 describe binder systems consisting of mixtures of polymers having different hydrophilic/hydrophobic properties. However, such mixtures involve the disadvantage that very frequently incompatibilities between the different substances lead to separation during the formation of layers. Furthermore, the precipitation of the hydrophobic polymers during the developing process proved to lead to silting of the developing machines.

Furthermore, copolymers consisting of only slightly hydrophilic monomers such as styrene, acrylic acid ester, methacrylic acid ester and the like with hydrophilic comonomers are described in various publications. Examples of such comonomers are semi-esters of maleic acid (DE-A-31 30 987, EP-B-71 881, EP-A-104 863), itaconic acid (EP-A-397 375, US-A-5 260 161) and acrylic acid and/or methacrylic acid (EP-A-487 343, US-A-4 304 832, US-A-4 123 276). The very tight play of the properties important for the use, which are layer adhesion, developability and printing ink receptivity proved to be disadvantageous in such polymers. This causes unacceptable fluctuations of the polymers' properties due to the variations of the polymer composition that can hardly be avoided in the production process.

DE-A-27 51 060 describes photosensitive compositions, wherein the binder is a reaction product of cellulose esters with cyclic, intramolecular acid anhydrides of dicarboxylic acids. These binders, however, are not oleophilic enough for the use in lithographic plates formulations.

Partially acetalized polyvinyl alcohols were provided with groups soluble in alkalines by means of special reactions (EP-A-48 876, US-A-4 387 151, US-A-3 732 106, DE-A-20 53 363, EP-A-152 819, DE-A-36 44 163, US-A-4 741 985, EP-A-208 145, DE-A-37 01 626, US-A-5 169 897, DE-A-36 44 162, US-A-4 940 646, DE-A-39 03 001 and US-A-5 219 699). However, the preparation of such binders involves considerable effort and is rather costly. Furthermore, the acetalization reactions result in a certain percentage of acetals having intermolecular bonds so that high-molecular gel particles are formed. These, in turn, cause undesired disturbances in the coating process.

Polymers that contain urethane groups were also described as binders for photosensitive compositions (EP-A-415 302, EP-A-406 599, EP-A-406 600, EP-A-414 099, US-A-4 983 491, US-A-4 950 582, US-A-4 877 711). The necessary functionalisation with hydrophilic groups, however, requires very high efforts regarding syntheses and involves high costs.

Despite this intensive research carried out in the field of photosensitive compositions for lithographic plates, there is still a need for improvement in all existing compositions, in particular regarding their sensitivity and the number of prints produced. Therefore, many of the compositions exhibit a high number of partially rather expensive components, which make an economical use impossible.

Thus, the object underlying this invention is to provide photosensitive compositions that do with as few components as possible (making them economically desirable) vis-à-vis the compositions described in the state of the art, which still have the same or - in individual areas - improved physical properties. In particular, an improved photosensitivity vis-à-vis the compositions described in the state of the art, improved printing ink receptivity and/or an increased number of prints produced from the corresponding lithographic plates are to be achieved.

Another object underlying this invention is the use of such a photosensitive composition for preparing lithographic plates.

These objects are achieved by a photosensitive composition comprising:
(A) a diazonium polycondensation product or
   a free radical polymerizable system consisting of photo initiators and unsaturated compounds which are free radical polymerizable or
   a hybrid system consisting of a diazonium polycondensation product and a free radical polymerizable system consisting of photo initiators and unsaturated compounds which are free radical polymerizable,
(B) a binder and
   optionally one or more exposure indicator(s), one or more dye(s) for increasing the contrast of the image as well as one or more acid(s) for stabilizing the photosensitive composition,
characterized in that the binder is a reaction product of a carboxyl-groups containing a polymer of formula (I)

P-(-X-COOH)ₙ (I),

wherein
- P: is a polymer,
- n: is an integer and
- X: is a single bond or a spacer group,
with one or more different 2-oxazoline(s) of the formula (II) 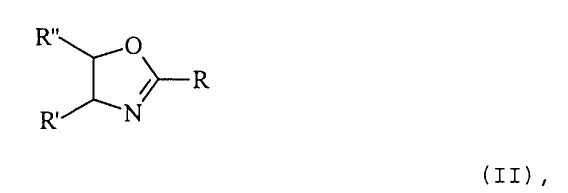 wherein
R is alkyl, aryl, aralkyl, alkoxy, aryloxy or aralkyloxy and
R' and R'' are independently hydrogen, alkyl or aryl, and wherein 5 to 100 mole % of the carboxyl groups can be reacted.

The surprising advantages of the invention are that by means of a rather simple synthesis and starting from inexpensive polymers available in large-scale technology, specific polymers can easily be prepared. The various possibilities of the process of this invention regarding the degree of reacted carboxyl groups, choice of substituent in the 2-oxazolines as well as the choice of the polymers to be modified make it possible to exactly predetermine a broad range of properties of the polymer. This way, tailor-made polymers are obtained suitable for a large variety of photo-crosslink mechanisms. In addition, it turned out that the achieved photosensitivities and both the chemical and mechanical properties of the photosensitive compositions, in particular for the use as offset lithographic plates can be considerably improved.

The first essential component of the photosensitive compositions of the invention is a reaction product of a carboxyl-groups containing polymer with one or more different 2-oxazoline(s). 2-oxazolines can easily be produced, cf. summary by T. G. Gant and A. I. Meyers in *Tetrahedron* vol. 50 (1994), pages 2297 - 2360. Alkyl, aryl, aralkyl, alkoxy, aryloxy or aralkyloxy groups are suitable substituents in the 2-position of the oxazolines. Especially preferred are alkyl and aryl. The substituents R' and R'' in the 4- and 5-positions of the 2-oxazolines may be - optionally also different from one another - hydrogen, alkyl or aryl. Hydrogen is especially preferred for R' and R''.

The alkyl and alkoxy groups preferably have 1 to 20, more preferably 1 to 6 carbon atoms. The aryl and aryloxy groups preferably have 6 to 18, more preferably 6 to 12 carbon atoms. The alkyl and/or aryl portions in the aralkyl and aralkyloxy groups are as defined above.

Especially preferred are 2-oxazolines wherein R' and R'' each are hydrogen and R is a methyl, ethyl or phenyl group.

As carboxyl-groups containing polymers of the formula P-(X-COOH)ₙ for the reaction with 2-oxazolines those may be used in which the carboxyl group is bound to the main chain either directly (i.e. X is a single bond) or via a spacer group.

In a particular embodiment of the present invention X is a spacer group of the formula

-O-CO-Y-

-O-CO-Y-CO-O-

or

-CO-O-Z-O-CO-Y-CO-O,

wherein Y is -CR¹R²CR³R⁴-, -CR¹=CR²- 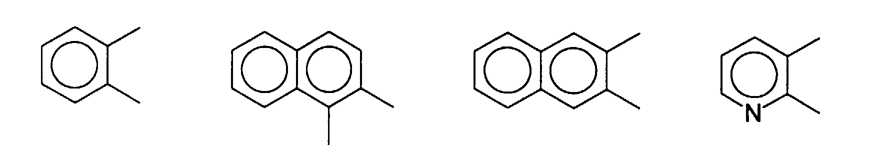 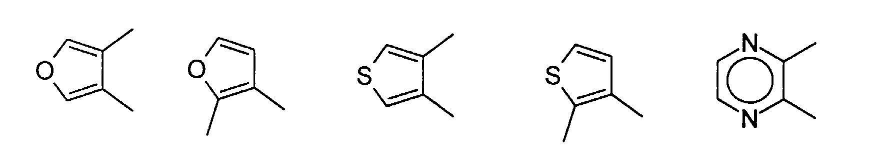 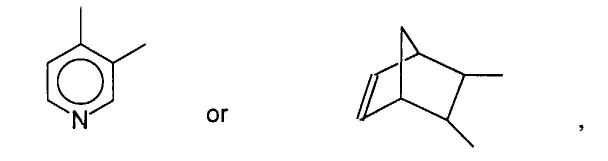 wherein R¹, R², R³, R⁴ each independently are hydrogen or alkyl and Z is -(CH₂)ₘ- with m = 1 to 5.

Preferred polymers P are cellulose ester of acetic acid, propionic acid, butyric acid or of combinations of these acids, as well as polymers based on vinyl alcohol, vinyl acetate and vinyl acetal units.

The reaction is best carried out in solvents in which the carboxyl-groups containing starting polymer and the end product dissolve well and which allow for reaction temperatures of from 90°C to 160°C at normal pressure. Preferable solvents are methyl glycol, ethyl glycol, butyl acetate, sulfolane, 2-ethyl hexanol, methylamyl ketone, ethylamyl ketone, diisobutyl ketone, amyl acetate, 3-methoxy-n-butyl acetate, methyl glycol acetate, ethyl glycol acetate, isopropyl acetate, propyl glycol, butyl glycol or 1-methoxypropanol-2. The reaction temperature may be reduced to less than 90°C if a catalyst is added. Suitable catalysts are preferably amines.

The reactions of 2-oxazolines with the carboxyl-groups containing polymers proceed in a very controlled and, in most cases, quantitative manner. They are therefore easy to repeat. Thus, the desired acid number of the binder can be adapted exactly to the used photosensitive system as well as to the desired developer.

The used starting polymers of the synthesis comprising the carboxyl groups directly bonded to the main chain may be those comprising acrylic acid, methacrylic acid, itaconic acid or carboxy styrene.

Also polymers having terminal carboxyl groups such as carboxyl-groups terminated, oligomeric α-methyl styrene as well as polycondensation products from bifunctional acide anhydrides, such as pyrromelithic acid anhydride having bifunctional amines fall within this group.

Furthermore, this group also includes polymers derived from maleic acid anhydride, with those copolymers of maleic acid anhydride being used preferably that form an open ring with alcohols having 1-8 carbons such as methanol, ethanol, propanol, butanol, pentanol and the like. In some cases also alcohols having unsaturated groups are advantageous for the preparation of semi-esters of maleic acid anhydride units. Such unsaturated alcohols are preferably allyl alcohol, hydroxy alkyl acrylates or hydroxy alkyl methacrylates.

The most suitable synthesis starting polymers comprising carboxyl groups connected via spacers include preferably those which were prepared by reacting OH-groups containing polymers with intramolecular, cyclic acid anhydrides of dicarboxylic acids. Examples are reaction products of partly or completely saponified polyvinyl acetates, polyvinyl acetales having free OH groups, copolymers of hydroxy alkyl(meth)acrylates, cellulose esters or phenolic resins with:
maleic acid anhydride or derivatives thereof (such as dimethylmaleinic acid anhydride or citraconic acid anhydride),
phthalic acid anhydride or substitution products (such as chloric, nitric or carboxyphthalic acid anhydride),
succinic acid anhydride or derivatives thereof (such as methyl succinic acid anhydride),
glutaric acid anhydride or derivatives thereof (such as 3-oxaglutaric acid anhydride, 3-methyl glutaric acid anhydride, 3,3-tetramethylene glutaric acid anhydride or camphoric acid anhydride),
naphthalene dicarboxylic acid anhydride or its substitution products (such as naphthalene-2,3-dicarboxylic acid anhydride or naphthalene-1,8-dicarboxylic acid anhydride),
pyridin-o-carboxylic acid anhydride or its substitution products, pyrazin-o-carboxylic acid anhydride or substitution products thereof,
furan-o-carboxylic acid anhydride or its substitution products,
thiophen-o-carboxylic acid anhydride or thiophen-2,5-dicarboxylic acid anhydride, their substitution products as well as their completely or partially hydrated derivatives or di- or polycyclic anhydrides, which are formed by Diels-Alder-reaction of a diene with maleic acid anhydride (such as addition products of furane, anthracene, cyclohexadiene-1,3, or cyclopentadiene and maleic acid anhydride).

Reaction products with maleic, phthalic, succinic and 3-oxaglutaric acid anhydride are preferred.

The molecular weight of the binders modified with 2-oxazolines may vary within broad ranges. Generally binders having average molecular weights of from 5,000 to 250,000, preferably from 10,000 to 100,000, are used.

The second substantial component of the photosensitive composition of this invention is a diazonium polycondensation product or a free radical polymerizable system, consisting of photo initiators and unsaturated compounds, which are free radical polymerizable, or a hybrid system comprising a diazonium polycondensation product and a free radical polymerizable system comprising photo initiators and unsaturated compounds which are free radical polymerizable.

In the photosensitive compositions according to the invention, diazonium polycondensation products known to the person skilled in the art can be used as diazonium polycondensation product. Such condensation products may for instance be prepared in a common manner by condensation of a diazo monomer described in EP-A-0 104 863 with a condensation agent, such as formaldehyde, acetaldehyde, propionaldehyde, butyraldehyde, isobutyraldehyde or benzaldehyde. Furthermore, mixed condensation products are used which, apart from the diazonium salt units, comprise other non-photosensitive units which are derived from condensable compounds, in particular from aromatic amines, phenols, phenol ethers, aromatic thioethers, aromatic hydrocarbons, aromatic heterocycles or organic acid amides. Especially advantageous examples of diazonium polycondensation products are reaction products of diphenylamine-4-diazonium salts, optionally having a methoxy group in the phenyl group bearing the diazo group, with formaldehyde or 4,4'-bis-methoxymethyl diphenyl ether. Aromatic sulfonates such as 4-tolylsulfonate or mesitylene sulfonate are particularly suitable as anions of these diazo resins. The diazonium polycondensation product is preferably present in the photosensitive compositions in an amount of from 3 to 60 weight %.

The second substantial component may also be a free radical polymerizable system. This is made up of photo initiators absorbing in the range of from 300 to 800 nm, preferably 300 to 450 nm, and free radical polymerizable components. The basic bodies and/or derivatives of acetophenone, benzophenone, (trichloromethyl)-1,3,5-triazine, benzoine, benzoine ethers, benzoine ketales, xanthone, thioxanthone, acridine or hexaryl-bis-imidazole are preferred photo initiators for the photosensitive compositions of this invention. The free radical polymerizable component of the composition of this invention is an acrylic or methacrylic acid derivative having one or more unsaturated group(s), preferably esters of acrylic or methacrylic acid in the form of monomers, oligomers or prepolymers. It may be present in solid or liquid form, solid and highly viscous forms being preferred. The compounds suitable as monomers include for instance trimethylol propane triacrylate and methacrylate, pentaerythrite triacrylate and methacrylate, dipentaerythritemono hydroxy pentaacrylate and methacrylate, dipenta erythrithexaacrylate and methacrylate, penta erythrite tetraacrylate and methacrylate, ditrimethylol propane tetraacrylate and methacrylate, diethylene glycol diacrylate and methacrylate, triethylene glycol diacrylate and methacrylate or tetraethylene glycol diacrylate and methacrylate. Suitable oligomers and/or prepolymers are urethane acrylate and methacrylate, epoxide acrylate and methacrylate, polyester acrylate and methacrylate, polyether acrylate and methacrylate or unsaturated polyester resins. The photo initiators and free radical polymerizable components are to be arranged in a manner known to the person skilled in the art, combinations of various photo initiators and different free radical polymerizable components being also advantageous. The weight ratio of the photo initiators is preferably 0.5 to 20% and that of the free radical polymerizable component 5 to 80%, based on the total solid content of the photosensitive composition.

A combination of the diazonium polycondensation products having a free radical polymerizable system comprising photo initiators and unsaturated compounds, which are free radical polymerizable, may be advantageous for certain applications. The compositions of such hybrid systems preferably comprise 1 to 50 % diazonium polycondensation products, 0.5 to 20 % photo initiators as well as 5 to 80 % free radical polymerizable components.

The exposure indicators usable in the photosensitive compositions of this invention are known to the person skilled in the art. Exposure indicators from the group of triaryl methane dyes (such as Victoria blue BO, Victoria blue R, Crystal Violet) or azo dyes (such as 4-phenyl azo diphenylamine, azo benzol or 4-N,N-dimethyl amino azo benzol) are preferred. The exposure indicators are present in the photosensitive composition at a ratio of 0.02 to 10 weight %, preferably 0.5 to 6 weight %.

Suitable dyes for improving the contrast of the image are those that dissolve well in the solvent or solvent mixture used for coating or are easily introduced in the disperse form of a pigment. Suitable contrast dyes include *inter alia* rhodamin dyes, methyl violet, anthrachinone pigments and phthalocyanine dyes and/or pigments.

Furthermore, the composition of this invention may comprise stabilizing acids. These stabilizing acids include phosphoric, citric, benzoic, m-nitrobenzoic, p-anilino azo-benzol sulfonic, p-toluene sulfonic or tartaric acid. In some formulations a mixture of several different acids is advantageous. Phosphoric acid is preferably used as stabilizing acid. The added acid preferably amounts to 0.2 to 3 weight %.

The photosensitive composition of this invention may also comprise a softening agent. Suitable softening agents include dibutyl phthalate, triaryl phosphate and dioctyl phthalate. Dioctyl phthalate is especially preferred. The amount of softening agent used is preferably 0.25 to 2 weight %.

The photosensitive compositions of this invention are preferably usable for producing lithographic plates. In addition, however, they may be used in recording materials for creating images on suitable carriers and receiving sheets, for creating reliefs that may serve as printing molds, screens and the like, as light-hardening varnishes for surface protection and for the formulation of UV-hardening printing inks.

For the preparation of planographic printing plates aluminum as the carrier is first roughened by brushing in a dry state, brushing with abrasive suspensions or electrochemically, e.g. in an hydrochloric acid electrolyte. The roughened plates, which were optionally anodically oxidized in sulfuric or phosphoric acid, are then subjected to a hydrophilizing aftertreatment, preferably in an aqueous solution of polyvinyl phosphonic acid, sodium silicate or phosphoric acid. The details of the above-mentioned substrate pretreatment are well-known to the person skilled in the art.

The dried plates are then coated with the photosensitive layers of organic solvents and/or solvent mixtures so that dry layer weights of preferably from 0.5 to 4 g/m², more preferably 0.8 to 3 g/m², are obtained.

In some cases the additional application of an oxygen-impermeable top layer to the photosensitive layer might be advantageous. This is especially advantageous in free radical polymerizable systems and in the hybrid systems of diazonium polycondensation products and free radical polymerizable systems. The polymers suitable for the top layer include polyvinyl alcohol, polyvinyl alcohol/polyvinyl acetate copolymers, polyvinyl pyrrolidone, polyvinyl pyrrolidone/polyvinyl acetate copolymers, polyvinyl methyl ether, polyacrylic acid and gelatine. The thickness of the oxygen-impermeable top layer is preferably 0.1 to 4 g/m², and more preferably 0.3 to 2 g/m².

The thus obtained lithographic plates are exposed and developed as common and known to the person skilled in the art. The developed plates are usually treated with a preservative ("rubber coating"). The preservatives are aqueous solutions of hydrophilic polymers, wetting agents and other additives.

For certain uses it is furthermore advantageous to increase the mechanical strength of the printing layers by means of a heat treatment or a combined use of heat and UV radiation. For this purpose, the plate is first treated with a solution that protects the non-image areas such that the heat treatment will cause no ink receptivity in these areas. A suitable solution is described e.g. in US-A-4 355 096.

The following examples serve to provide a more detailed explanation of the invention.

### Preparation Example 1

300 g Scripset 540, (butyl semi-ester of the maleic acid anhydride/styrene copolymers available from *Monsanto*) are dissolved in 1,500 ml dipropylene glycol dimethyl ether and after adding 45 g 2-phenyl-Δ²-oxazoline stirred for 5 hours at 120°C under nitrogen atmosphere. After adding hexane, a polymer can be decanted which after dissolution in methanol, precipitation with water and drying for 24 hours at 40°C has an acid number of 125.

### Preparation Example 2

200 g Scripset 540, are dissolved in 1,000 ml ethylene glycol methyl ether acetate and after adding 21.2 g 2-ethyl-D²-oxazoline and 15.7 g 2-phenyl-Δ²-oxazoline stirred for 5 hours at 120°C under nitrogen atmosphere. After adding hexane, a polymer can be decanted which after dissolution in methanol, precipitation with water and 24 hours drying at 40°C has an acid number of 115.

### Preparation Example 3

300 g CAP, (cellulose acetate phthalate available from *Eastman Kodak*) are dissolved in 1,500 ml methyl glycolacetate and after adding 39.5 g 2-phenyl-Δ²-oxazoline stirred for 3 hours at 110°C under nitrogen atmosphere. After adding hexane, a polymer can be decanted which after dissolution in methanol, precipitation with water and 24 hours drying at 40°C has an acid number of 72.

### Preparation Example 4

200 g Scripset 540, are dissolved in 1,000 ml dipropylene glycol dimethyl ether and after adding 80 g 2-ethyl-Δ²-oxazoline stirred for 90 minutes at 120°C under nitrogen atmosphere. After addition of hexane, a polymer can be obtained which after drying for 24 hours at 40°C has an acid number of 46.

### Preparation Example 5

### (Primary step for Preparation Example 6; according to EP-A-0 152 819)

250 g Mowital B60T, (polyvinyl butyral available from *HOECHST* having an acetal content of 70 weight %, a vinyl alcohol content of 26 weight % and an acetate content of 3 weight %) are dissolved in 5,000 ml methyl ethyl ketone and after adding 200 g maleic acid anhydride and 10 ml triethyl amine stirred for 6 hours at 80°C. Upon precipitation in water, washing the polymer with water and drying for 24 hours at 40°C, the product having the acid number 100 is obtained.

### Preparation Example 6

100 g of the polymer from Preparation Example 5 are dissolved in 2,000 ml methyl ethyl ketone and after adding 18.6 g 2-ethyl-Δ²-oxazoline and 10 ml triethyl amine stirred for 6 hours at 50°C. The polymer is precipitated in water, washed with water and dried for 24 hours at 40°C. The obtained product has an acid number of 52.

### Preparation Example 7

100 g of the polymer from Preparation Example 5 are dissolved in 1,500 ml methyl ethyl ketone and after adding 10.2 g 2-phenyl-Δ²-oxazoline and 10 ml triethyl amine stirred for 6 hours at 70°C. The polymer is precipitated using hexane, the lumpy material is decanted and again dissolved in methanol. The methanolic solution is precipitated in water, the polymer is filtered off and dried for 24 hours at 40°C. The product has an acid number of 77.

### Preparation Example 8

### (Primary step for Preparation Example 9; according to EP-A-0 152 819)

125 g Mowital B60T, (polyvinyl butyral available from *HOECHST* having an acetal content of 70 weight %, a vinyl alcohol content of 26 weight % and an acetate content of 3 weight %) are dissolved in 2,500 ml methyl ethyl ketone and after adding 30 g pyridin-2,3-dicarboxylic acid anhydride and 5 ml triethyl amine stirred for 6 hours at 80°C. Upon precipitation in water, washing the polymer with water and drying for 24 hours at 40°C, a product having the acid number 70 is obtained.

### Preparation Example 9

100 g of the polymer from Preparation Example 8 are dissolved in 2,000 ml methyl ethyl ketone and after adding 6.5 g 2-ethyl-Δ²-oxazoline and 2 ml triethyl amine stirred for 6 hours at 50°C. The polymer is precipitated in water, washed with water and dried for 24 hours at 40°C. The product has an acid number of 35.

### Example 1

A coating solution is prepared from the components:

| | |
|---|---|
| 6.45 g | binder according to Preparation Example 1 |
| 3 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtering the solution, it is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The printing layer is exposed under a silver film halftone step wedge having a tonal range of 0.15 to 1.95, wherein the density increments amount to 0.15, to give a negative model using a metal halogenide lamp (MH burner, available from *Sack*) of 300 mJ/cm².

The exposed coating is treated for 30 seconds with a developer solution comprising

| | |
|---|---|
| 3.4 parts | by weight Rewopol NLS 28, (*REWO*) |
| 1.8 parts | by weight 2-phenoxy ethanol |
| 1.1 parts | by weight diethanol amine |
| 1.0 parts | by weight Texapon, 842 (*Henkel*) |
| 0.6 parts | by weight Nekal, BX Paste (*BASF*) |
| 0.2 parts | by weight 4-toluene sulfonic acid |
| 91.9 parts | by weight water. |

Then the developer solution is again rubbed over the surface for another 30 seconds using a tampon and then the entire plate is rinsed with water. After this treatment the exposed portions remain on the plate. For the assessment of its photosensitivity the plate is blackened in a wet state using a printing ink.

The plate's ink receptivity is good and exposed microscopic lines are very well reproduced. The gray wedge is completely covered up to step 2 and partially covered up to step 10.

For the preparation of a lithographic plate a printing layer is applied to the aluminum foil, as explained above, exposed, developed and after rinsing with water the developed plate is wiped and rubbed with an aqueous solution of 0.5% phosphoric acid and 6% gum arabic. The thus prepared plate is loaded in a sheet-fed offset printing machine and under normal printing conditions provides 120,000 copies of good quality. The plate could be used for more prints.

### Example 2

A coating solution is prepared from the following components:

| | |
|---|---|
| 5.45 g | binder according to Preparation Example 2 |
| 4 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 9 are partially covered.

The thus prepared plate is loaded in a sheet-fed offset printing machine and under normal printing conditions provides 100,000 copies of good quality. The plate could be used for more prints.

### Example 3

A coating solution is prepared from the following components:

| | |
|---|---|
| 6.95 g | binder according to Preparation Example 3 |
| 2.5 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 11 are partially covered.

The thus prepared plate is loaded in a sheet-fed offset printing machine and under normal printing conditions provides 100,000 copies of good quality. The plate could be used for more prints.

### Example 4

A coating solution is prepared from the following components:

| | |
|---|---|
| 5.45 g | binder according to Preparation Example 4 |
| 4 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 10 are partially covered.

The thus prepared plate is loaded in a sheet-fed offset printing machine and under normal printing conditions provides 100,000 copies of good quality. The plate could be used for more prints.

### Example 5

A coating solution is prepared from the following components:

| | |
|---|---|
| 6.8 g | binder according to Preparation Example 6 |
| 2 g | polycondensation product from 1 mole 3-methoxy diphenylamine-4-diazonium sulfate and 1 mole 4,4'-bis-methoxymethyldiphenyl ether precipitated as mesitylene sulfonate |
| 1 g | Renol blue B2G (Cu-phthalocyanine pigment preparation comprising polyvinyl butyral available from *HOECHST*) |
| 0.15 g | 4-phenyl azo diphenylamine |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of sodium silicate by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The gray wedge is completely covered up to step 4 and partially covered up to step 12.

The thus prepared plate is loaded in a sheet-fed offset printing machine and under normal printing conditions provides 100,000 copies of good quality. The plate could be used for more prints.

### Example 6

A coating solution is prepared from the following components:

| | |
|---|---|
| 5.55 g | binder according to Preparation Example 2 |
| 4 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of sodium silicate by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 9 are partially covered.

The thus prepared plate is loaded in a sheet-fed offset printing machine and under normal printing conditions provides 100,000 copies of good quality. The plate could be used for more prints.

### Example 7

A coating solution is prepared from the following components:

| | |
|---|---|
| 7.45 g | binder according to Preparation Example 4 |
| 2 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 11 are partially covered.

The thus prepared plate is loaded in a sheet-fed offset printing machine and under normal printing conditions provides 100,000 copies of good quality. The plate could be used for more prints.

### Example 8

A coating solution is prepared from the following components:

| | |
|---|---|
| 6.8 g | binder according to Preparation Example 7 |
| 2 g | polycondensation product from 1 mole 3-methoxy diphenylamine-4-diazonium sulfate and 1 mole 4,4'-bis-methoxymethyldiphenyl ether precipitated as mesitylene sulfonate |
| 1 g | Renol blue B2G (Cu-phthalocyanine pigment preparation comprising polyvinyl butyral available from *HOECHST*) |
| 0.15 g | 4-phenyl azo diphenylamine |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of sodium silicate by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first step of the gray wedge is completely covered and those up to step 12 are partially covered.

The thus prepared plate is loaded in a sheet-fed offset printing machine and under normal printing conditions provides 100,000 copies of good quality. The plate could be used for more prints.

### Example 9

A coating solution is prepared from the following components:

| | |
|---|---|
| 5.2 g | binder according to Preparation Example 3 |
| 2.88 g | of a 80% methyl ethyl ketone solution of an urethane acrylate prepared by reacting Desmodur N 100, (available from *Bayer)* comprising hydroxy ethyl acrylate and pentaerythrite triacrylate having a double-bond content of 0.5 double bonds/100 g when all isocyanate groups are completely reacted |
| 1.42 g | dipentaerythritol pentaacrylate |
| 0.165 g | 2-(4-methoxy naphth-1-yl)-4,6-bis-(trichloromethyl)-s-triazine |
| 0.33 g | polycondensation product from 1 mole 3-methoxy diphenylamine-4-diazonium sulfate and 1 mole 4,4'-bis-methoxymethyldiphenyl ether precipitated as mesitylene sulfonate |
| 0.165 g | Victoria blue (C.I. Solvent Blue 5) |
| 0.12 g | 4-phenyl azo diphenylamine |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

Then, an oxygen-impermeable layer of 0.3 g/m² dry layer weight was applied analogously by applying a coating of a solution of the following composition:

| | |
|---|---|
| 50 g | polyvinyl alcohol (Airvol 203 available from *Airproducts;* 12 % residual acetyl groups) |
| 270 g | water. |

Drying also took place for 5 minutes at 95°C.

The plate is exposed, developed, blackened and used for printing as described in Example 1.

The plate's ink receptivity is good and exposed microscopic lines are very well reproduced. The first step of the gray wedge is completely covered and those up to step 11 are partially covered.

The thus prepared plate is loaded in a sheet-fed offset printing machine and under normal printing conditions provides 100,000 copies of good quality. The plate could be used for more prints.

### Example 10

A coating solution is prepared from the following components:

| | |
|---|---|
| 3.54 g | binder according to Preparation Example 2 |
| 4.62 g | of a 80% methyl ethyl ketone solution of an urethane acrylate prepared by reacting Desmodur N 100, (available from *Bayer)* comprising hydroxy ethyl acrylate and pentaerythrite triacrylate having a double-bond content of 0.5 double bonds/100 g when all isocyanate groups are completely reacted |
| 0.165 g | 2-(4-methoxy naphth-1-yl)-4,6-bis-(trichloromethyl)-1,3,5-triazine |
| 0.16 g | 4,4'-N,N-diethyl amino benzo phenone |
| 0.19 g | 3-mercapto-1,2,4-triazol |
| 0.12 g | congo red |
| 0.2 g | leuco Crystal Violet. |

These components are dissolved under stirring in 100 ml of a mixture comprising

| | |
|---|---|
| 35 parts | by volume methyl glycol |
| 25 parts | by volume methanol |
| 40 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1.85 g/m².

Then, an oxygen-impermeable layer of 1.7 g/m² dry layer weight was applied analogously by applying a coating of an aqueous solution of the following composition:

| | |
|---|---|
| 50 g | polyvinylalcohol (Airvol 203 available from *Airproducts;* 12 % residual acetyl groups) |
| 270 g | water. |

Drying also took place for 5 minutes at 95°C.

The plate is exposed as described in Example 1; however, the amount of light is 20 mJ/cm². Immediately upon exposure, the plates were heated to 95°C for 1 minute in order to amplify the photo polymerization taking place. Developing and blackening takes place as described in Example 1.

The plate's ink receptivity is good. The first step of the gray wedge is completely covered and those up to step 6 are partially covered.

The thus prepared plate is loaded in a sheet-fed offset printing machine and under normal printing conditions provides 100,000 copies of good quality. The plate could be used for more prints.

### Example 11

A coating solution is prepared from the following components:

| | |
|---|---|
| 7.45 g | binder according to Preparation Example 1 |
| 2 g | polycondensation product from 1 mole diphenylamine-4-diazonium sulfate and 1 mole formaldehyde precipitated as hexafluorophosphate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first 2 steps of the gray wedge are completely covered and those up to step 9 are partially covered.

The thus prepared plate is loaded in a sheet-fed offset printing machine and under normal printing conditions provides 100,000 copies of good quality. The plate could be used for more prints.

### Example 12

A coating solution is prepared from the following components:

| | |
|---|---|
| 6.45 g | binder according to Preparation Example 9 |
| 3 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The plate's ink receptivity is good and exposed microscopic lines are very well reproduced. The first 2 steps of the gray wedge are completely covered and those up to step 7 are partially covered.

The thus prepared plate is loaded in a sheet-fed offset printing machine and under normal printing conditions provides 100,000 copies of good quality. The plate could be used for more prints.

### Comparative Example 1

A coating solution is prepared from the following components:

| | |
|---|---|
| 7.45 g | Scripset 540, (butyl semi-ester of the maleic acid anhydride/styrene copolymer available from *Monsanto*) |
| 2 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The ink receptivity duringmanual blackening of the plate is insufficient and exposed microscopic lines are poorly reproduced. The first step of the gray wedge is completely covered and those up to step 9 are partially covered.

The thus prepared plate is loaded in a sheet-fed offset printing machine. During printing the plate's ink behavior is poor and the ink receptivity of the solids is spotted. Printing 100,000 copies shows clear wear in the solids as well as in the halftone dots.

These results show that the modification of Scripset 540, according to this invention with 2-oxazolines as described in Preparation Examples 1, 2 and 4 and use according to this invention as described in Examples 1, 2, 4, 6 as well as 7 causes a significant improvement of the properties relevant in its use.

### Comparative Example 2

A coating solution is prepared from the following components:

| | |
|---|---|
| 5.45 g | CAP (cellulose-acetate/phthalate available from *Eastman Kodak*) |
| 4 g | polycondensation product from 1 mole 3-methoxy diphenylamine-4-diazonium sulfate and 1 mole 4,4'-bis-methoxymethyldiphenyl ether precipitated as mesitylene sulfonate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed, blackened and used for printing as described in Example 1.

The ink receptivity during manual blackening of the plate and the sensitivity are insufficient (first step of the gray wedge is completely covered and those up to step 5 are partially covered).

The thus prepared plate is loaded in a sheet-fed offset printing machine. During printing the plate's ink behavior is poor and the ink receptivity of the solids is spotted. Printing 60,000 copies shows clear wear in the solids as well as in the halftone dots.

These results show that the modification of CAP, according to this invention with 2-oxazolines as described in Preparation Example 3 and use according to this invention as described in Example 3 causes a significant improvement of the properties relevant in its use.

### Comparative Example 3

A coating solution is prepared from the following components:

| | |
|---|---|
| 6.8 g | polymer according to Preparation Example 5 (according to EP 0 152 819) |
| 2 g | polycondensation product from 1 mole 3-methoxy diphenylamine-4-diazonium sulfate and 1 mole 4,4'-bis-methoxymethyldiphenyl ether precipitated as mesitylene sulfonate |
| 1 g | Renol blue B2G (Cu-phthalo cyanine pigment preparation comprising polyvinyl butyral available from *HOECHST*) |
| 0.15 g | 4-phenyl azo diphenylamine |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of sodium silicate by means of common methods and the coating is dried for 4 minutes at 90°C. The weight of the printing layer amounts to approx. 1 g/m².

The plate is exposed, developed, blackened and used for printing as described in Example 1.

The reproduction of fine halftone dots is unsatisfactory. The first step of the gray wedge is completely covered and those up to step 11 are partially covered.

In Examples 5 and 8, the modification of the polymer of Preparation Example 5 according to this invention with 2-ethyl-Δ²-oxazoline (Preparation Example 6) or 2-phenyl-Δ²-oxazoline (Preparation Example 7) shows markedly improved dissolution for fine details.

### Comparative Example 4

A coating solution is prepared from the following components:

| | |
|---|---|
| 7.45 g | Scripset 540, (butyl semi-ester of the maleic acid anhydride/styrene copolymer available from *Monsanto*) |
| 2 g | polycondensation product from 1 mole diphenylamine-4-diazonium sulfate and 1 mole formaldehyde precipitated as hexafluorophosphate |
| 0.5 g | Victoria blue (C.I. Solvent Blue 5) |
| 0.05 g | phosphoric acid. |

These components are dissolved under stirring in 100 ml of a mixture comprising

| | |
|---|---|
| 30 parts | by volume methyl glycol |
| 45 parts | by volume methanol |
| 25 parts | by volume methyl ethyl ketone. |

After filtration, the solution is applied to an electrochemically roughened and anodized aluminum foil that was subjected to an aftertreatment using an aqueous solution of polyvinyl phosphonic acid by means of common methods and the coating is dried for 4 minutes at 90°C. The weight of the printing layer amounts to approx. 1 g/m².

The plate is exposed, developed and blackened as described in Example 1.

The thus obtained plate bears only an extremely weak image since the major portion of the layer was removed by the developer. In contrast to Scripset 540, modified according to this invention with 2-phenyl-A²-oxazoline (see Preparation Example 1 and Example 11), printing is impossible with this plate.

## Claims

1. Photosensitive composition, comprising:
(A) a diazonium polycondensation product or
a free radical polymerizable system consisting of photo initiators and unsaturated compounds which are free radical polymerizable or
a hybrid system consisting of a diazonium polycondensation product and a free radical polymerizable system consisting of photo initiators and unsaturated compounds which are free radical polymerizable and
(B) a binder
characterized in that the binder is a reaction product of a carboxyl-groups containing polymer of formula (I)
P-(-X-COOH)ₙ (I),
wherein
P is a polymer,
n is an integer and
X is a single bond or a spacer group,
with one or more different 2-oxazoline(s) of the formula (II) 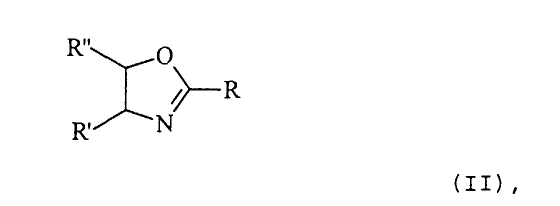 wherein
R is alkyl, aryl, aralkyl, alkoxy, aryloxy or aralkyloxy and R' and R" are independently hydrogen, alkyl or aryl and wherein 5 to 100 mole % of the carboxyl groups can be reacted.

2. Composition of claim 1, wherein X is a spacer group of the formulae
-O-CO-Y-
-O-CO-Y-CO-O-
or
-CO-O-Z-O-CO-Y-CO-O-,
wherein Y is the moiety -CR¹R²-CR³R⁴-, -CR¹=CR²- 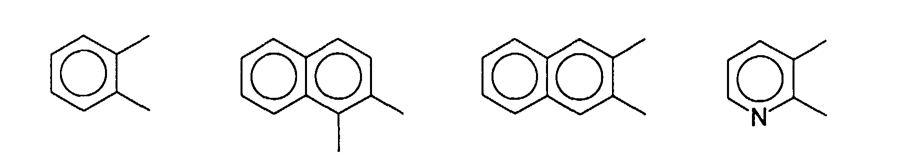 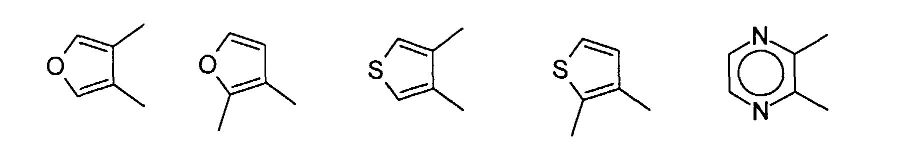 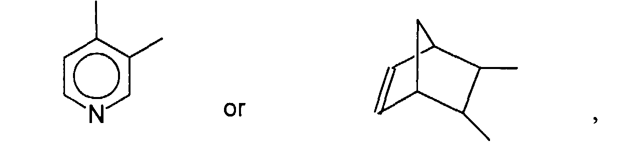
wherein R¹, R², R³, R⁴ are independently a hydrogen or an alkyl,
and Z is the moiety -(CH₂)ₘ- with m = 1 to 5.

3. Composition of claim 1 or 2, wherein the 2-oxazolines used are those with R' and R'' being hydrogen and R being methyl, ethyl or phenyl.

4. Composition of any of claims 1 to 3, wherein P is a cellulose ester of acetic acid, propionic acid, butyric acid or a combination of these acids.

5. Composition of any of claims 1 to 3, wherein P consists of vinyl alcohol, vinyl acetate and vinyl acetale units.

6. Composition of claim 1 or 3, wherein the polymer containing carboxyl groups used for the reaction with 2-oxazolines is a copolymer of maleic acid anhydride which was ring-opened with alcohols having a carbon number of 1 to 8.

7. Composition of any of claims 1 to 6 containing a polycondensation product of 3-methoxy-diphenylamine-4-diazonium sulfate and 4,4'-bis-methoxymethyldiphenyl ether precipitated from aqueous solution as organic sulfonate, tetrafluoroborate, hexafluorophosphate, hexafluoroantimonate or hexafluoroarsenate as the photosensitive component.

8. Composition of any of claims 1 to 6 containing a free radical-forming photo initiator or mixtures of photo initiators and coinitiators rendering the mixture sensitive to the wavelengths from 300 to 800 nm as well as free radical polymerizable components with unsaturated groups as the photosensitive component.

9. Composition of any of claims 1 to 6 containing a diazonium polycondensation product according to claim 6 in combination with a free radical photo initiator system as well as free radical polymerizable components according to claim 7 as the photosensitive components.

10. Composition of any of claims 1 to 9 additionally comprising one or more exposure indicator(s), one or more dye(s) for increasing the contrast of the image as well as one or more acid(s) for stabilizing the photosensitive composition.

11. Use of a composition of claim 10 for coating lithographic plates.

12. Lithographic plates coated with a composition of claim 10.

13. Process for producing a polymer of formula (I) of claim 1 rich in carboxyl groups, wherein X is the spacer group -O-CO-Y-, characterized in that the OH groups in the polymer P are reacted with intramolecular cyclic anhydrides of dicarboxylic acids.

## Patentansprüche

1. Lichtempfindliche Zusammensetzung, enthaltend:
(A) ein Diazoniumpolykondensationsprodukt oder
ein radikalisch polymerisierbares System bestehend aus Photoinitiatoren und ungesättigten Verbindungen, die radikalisch polymerisierbar sind oder
ein Hybridsystem bestehend aus einem Diazoniumpolykondensationsprodukt und einem radikalisch polymerisierbaren System bestehend aus Photoinitiatoren und ungesättigten Verbindungen, die radikalisch polymerisierbar sind, und
(B) ein Bindemittel
dadurch gekennzeichnet, daß das Bindemittel ein Umsetzungsprodukt eines carboxylgruppenhaltigen Polymers der Formel I
P-(-X-COOH)ₙ (I)
in der
P ein Polymer bedeutet,
n eine ganze Zahl ist und
X eine Einfachbindung oder eine Spacergruppe ist,
mit einem oder mehreren verschiedenen 2-Oxazolinen der Formel II 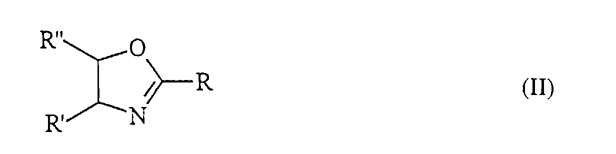 ist, in der
R einen Alkyl-, Aryl-, Aralkyl, Alkoxy, Aryloxy- oder Aralkyloxyrest und R' und R" unabhängig voneinander ein Wasserstoff, einen Alkyl- oder Arylrest darstellen und wobei 5 bis 100 Mol-% der Carboxylgruppen umgesetzt sein können.

2. Zusammensetzung nach Anspruch 1, wobei X eine Spacergruppe der Formeln
-O-CO-Y-
-O-CO-Y-CO-O-
oder
-CO-O-Z-O-CO-Y-CO-O-
darstellt, in denen Y der Rest -CR¹R²-CR³R⁴-, -CR¹=CR²- 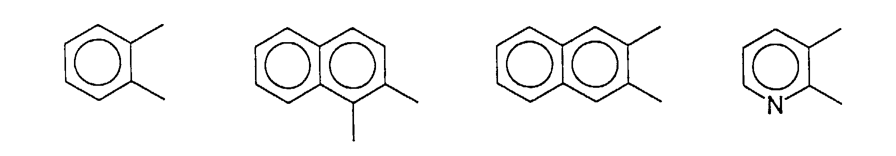 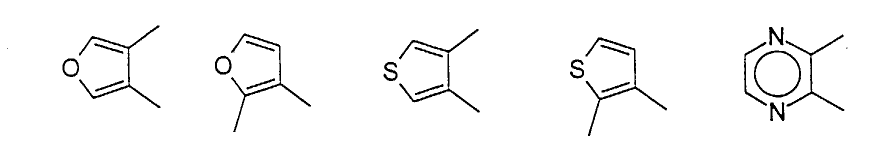 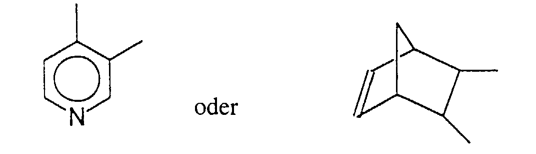 ist,
wobei R¹, R², R³, R⁴ jeweils unabhängig ein Wasserstoffatom oder einen Alkylrest bedeuten,
und Z der Rest -(CH₂)ₘ- mit m = 1 bis 5 ist.

3. Zusammensetzung nach Anspruch 1 oder 2, in der als 2-Oxazoline solche mit R' und R" gleich Wasserstoff und R gleich Methyl, Ethyl oder Phenyl verwendet werden.

4. Zusammensetzung nach einem der Ansprüche 1 bis 3, wobei P ein Celluloseester der Essigsäure, Propionsäure, Buttersäure oder Kombinationen dieser Säuren ist.

5. Zusammensetzung nach einem der Ansprüche 1 bis 3, wobei P aus Vinylalkohol-, Vinylacetat- und Vinylacetaleinheiten aufgebaut ist.

6. Zusammensetzung nach Anspruch 1 oder 3, in der als carboxylgruppenhaltiges Polymer zur Umsetzung mit 2-Oxazolinen ein Copolymer von Maleinsäureanhydrid verwendet wird, das mit Alkoholen der Kohlenstoffzahl 1 bis 8 ringgeöffnet wurde.

7. Zusammensetzung nach einem der Ansprüche 1 bis 6, in der als lichtempfindliche Komponente ein Polykondensationsprodukt aus 3-Methoxy-diphenylamin-4-diazoniumsulfat und 4,4'-Bis-methoxymethyldiphenylether, das aus wäßriger Lösung als organisches Sulfonat, Tetrafluoroborat, Hexafluorophosphat, Hexafluoroantimonat oder Hexafluoroarsenat ausgefällt wurde, enthalten ist.

8. Zusammensetzung nach einem der Ansprüche 1 bis 6, in der als lichtempfindliche Komponente ein radikalbildender Photointiator oder Mischungen aus Photoinitiatoren und Coinitiatoren, die das Gemisch für den Wellenlängenbereich von 300 bis 800 nm sensibilisieren, sowie radikalisch polymerisierbare Bestandteile mit ungesättigten Gruppen enthalten sind.

9. Zusammensetzung nach einem der Ansprüche 1 bis 6, in der als lichtempfindliche Komponenten ein Diazoniumpolykondensationsprodukt gemäß Anspruch 6 in Kombination mit einem radikalischen Photoinitiatorsystem sowie radikalisch polymerisierbaren Bestandteilen gemäß Anspruch 7 enthalten sind.

10. Zusammensetzung nach einem der Ansprüche 1 bis 9, in dem zusätzlich ein oder mehrere Belichtungsindikatoren, ein oder mehrere Farbstoffe zur Erhöhung des Bildkontrastes sowie eine oder mehrere Säuren zur Stabilisierung der lichtempfindlichen Zusammensetzung enthalten sind.

11. Verwendung einer Zusammensetzung nach Anspruch 10 zur Beschichtung von Druckplatten.

12. Druckplatten, beschichtet mit einer Zusammensetzung nach Anspruch 10.

13. Verfahren zur Herstellung eines Polymers der Formel (I) von Anspruch 1, welches reich an Carboxylgruppen ist, wobei X die Spacergruppe -O-CO-Y- ist, dadurch gekennzeichnet, daß die OH-Gruppen im Polymer P mit intramolekularen cyclischen Anhydriden von Dicarbonsäuren umgesetzt werden.

## Revendications

1. Composition photosensible comprenant :
(A) un produit de polycondensation de diazonium ou un système polymérisable par voie radicalaire constitué de photo-initiateurs et de composés insaturés qui sont polymérisables par voie radicalaire ou un système hybride constitué d'un produit de polycondensation de diazonium et d'un système polymérisable par voie radicalaire constitué de photo-initiateurs et de composés insaturés qui sont polymérisables par voie radicalaire et
(B) un liant
caractérisée en ce que le liant est un produit de réaction d'un polymère contenant des groupes carboxyle de formule (I)
P-(-X-COOH)ₙ (I)
dans laquelle
P est un polymère,
n est un nombre entier et
X est une liaison simple ou un groupe écarteur,
avec une ou plusieurs 2-oxazolines différentes de formule (II) 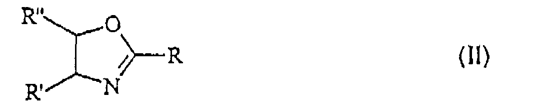 dans laquelle
R est un groupe alkyle, aryle, aralkyle, alcoxy, aryloxy ou aralkyloxy, et R' et
R" sont indépendamment des atomes d'hydrogène ou des groupes alkyle ou aryle, et dans laquelle 5 à 100% en moles des groupes carboxyle peuvent réagir.

2. Composition selon la revendication 1, dans laquelle X est un groupe écarteur de formule :
-O-CO-Y-
-O-CO-Y-CO-O-
ou
-CO-O-Z-O-CO-Y-CO-O-,
formules dans lesquelles Y est le groupement -CR¹R²-CR³R⁴-, -CR¹ = CR²- 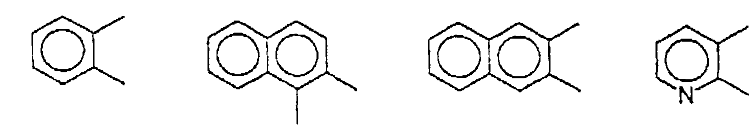 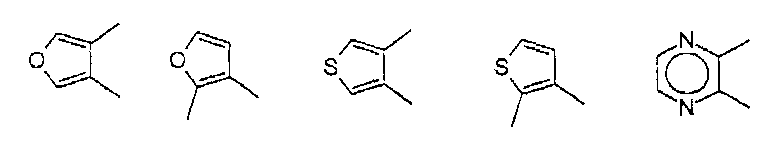 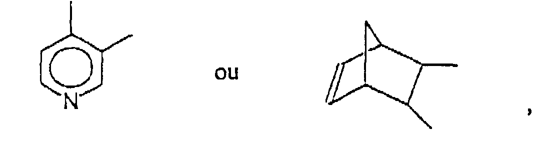
dans lesquelles R¹, R², R³, R⁴ sont indépendamment un atome d'hydrogène ou un groupe alkyle,
et Z est le groupement -(CH₂)ₘ-, avec m = 1 à 5.

3. Composition selon la revendication 1 ou 2, dans laquelle les 2-oxazolines utilisées sont celles dans lesquelles R' et R" sont des atomes d'hydrogène et R est un groupe méthyle, éthyle ou phényle.

4. Composition selon l'une quelconque des revendications 1 à 3, dans laquelle P est un ester de cellulose d'acide acétique, d'acide propionique, d'acide butyrique ou d'une combinaison de ces acides.

5. Composition selon l'une quelconque des revendications 1 à 3, dans laquelle P est constitué de motifs alcool vinylique, acétate de vinyle et vinylacétal.

6. Composition selon l'une quelconque des revendications 1 ou 3, dans laquelle le polymère contenant des groupes carboxyle utilisé pour la réaction avec les 2-oxazolines est un copolymère d'anhydride d'acide maléique dont le cycle a été ouvert avec des alcools comportant un nombre d'atomes de carbone de 1 à 8.

7. Composition selon l'une quelconque des revendications 1 à 6, contenant un produit de polycondensation de sulfate de 3-méthoxydiphénylamine-4-diazonium et d'éther 4,4'-bisméthoxyméthyldiphénylique précipité en solution aqueuse sous forme de sulfate, tétrafluoroborate, hexafluorophosphate, hexafluoroantimoniate ou hexafluoroarséniate organique en tant que constituant photosensible.

8. Composition selon l'une quelconque des revendications 1 à 6, contenant un photo-initiateur formant un radical libre ou des mélanges de photo-initiateurs et de co-initiateurs rendant le mélange sensible aux longueurs d'onde de 300 à 800 nm ainsi que des constituants polymérisables par voie radicalaire avec des groupes insaturés en tant que constituant photosensible.

9. Composition selon l'une quelconque des revendications 1 à 6, contenant un produit de polycondensation de diazonium selon la revendication 6 en combinaison avec un système de photo-initiateur radicalaire ainsi que des constituants polymérisables par voie radicalaire selon la revendication 7 en tant que constituants photosensibles.

10. Composition selon l'une quelconque des revendications 1 à 9, comprenant en outre un ou plusieurs indicateurs d'exposition, un ou plusieurs colorants pour augmenter le contraste de l'image, ainsi qu'un ou plusieurs acides pour stabiliser la composition photosensible.

11. Utilisation d'une composition selon la revendication 10 pour revêtir des plaques lithographiques.

12. Plaques lithographiques revêtues d'une composition selon la revendication 10.

13. Procédé de production d'un polymère de formule (I) selon la revendication 1 riche en groupes carboxyle, dans lequel X est le groupe écarteur -O-CO-Y-, caractérisé en ce que les groupes OH dans le polymère P sont mis à réagir avec des anhydrides cycliques intramoléculaires d'acides dicarboxyliques.
